# EUROPÄISCHE PATENTANMELDUNG

(11) **EP 0 591 668 A1**
(43) Veröffentlichungstag der Anmeldung: **13.04.1994**
(21) Anmeldenummer: 93113562.8
(22) Anmeldetag: 25.08.1993
(51) Int. Cl.: H01L 23/498, H01L 23/495

(54) **Verfahren zur Montage von integrierten Halbleiterschaltkreisen**

(30) Priorität: 29.09.1992 DE 4232625
(71) Anmelder: SIEMENS AKTIENGESELLSCHAFT, D-80333 München (DE)
(72) Erfinder: Scheuenpflug, Richard, Dipl.-Ing. (FH), D-93161 Kleinprüfening (DE)

(57) **Zusammenfassung**

Das erfindungsgemäße Verfahren zur Montage von Halbleiterschaltkreisen weist folgende Schritte auf: Auf einen Leiterrahmen (1) wird eine doppelseitig beschichtete Klebefolie (6) aufgebracht. Diese Folie (6) weist eine Aussparung (8) auf. Am Rand dieser Aussparung (8) sind weitere Aussparungen (7) vorgesehen. Die Aussparung (8) ermöglicht ein einfaches Plazieren und Bonden des Schaltkreises (5). Die weiteren Aussparungen (7) sichern eine Verankerung der anschließend in die Aussparung (7, 8) eingebrachten Vergußmasse (10) mit der Folie (6) und dem Leiterrahmen (1).

## Beschreibung

Die Erfindung betrifft ein Verfahren zur Montage von integrierten Halbleiterschaltungen.

Unter dem Begriff Montage werden im Rahmen vorliegender Erfindung generell Bauformen verstanden, bei denen Schaltkreissysteme in einem Verbund mit einer Trägerfolie bzw. einem Film montiert werden und zwischen Anschlußstellen, sogenannten Pads auf dem Schaltkreissystem und Leiterbahnen auf der Tragerfolie, die zur Schaffung eines elektrischen Anschlusses nach außen dienen, eine Verbindung durch elektrische Leiter hergestellt wird. Derartige Schaltkreissystem werden insbesondere für Mikroschaltungskarten, wie Kreditkarten, Bankkarten, Parkkarten, Wertkarten für Telefongespräche in öffentlichen Zellen usw. benutzt.

Die Erfindung geht von einem Verfahren aus, wie es durch die US-PS 5,147,982 offenbart wird.

Beim dortigen Verfahren wird zunächst eine ebene Gesamtheit von Leitern hergestellt, wobei ein Bereich eines der Leiter als Chipinsel etwa in der Mitte der Gesamtheit von Leitern angeordnet ist und jeweils ein Ende jedes der anderen Leiter als Kontaktierfläche diesem Bereich benachbart ist. In eine Folie werden Aussparungen angebracht, wobei eine der Aussparungen kleiner als die Abmessung der Chipinsel ist und die anderen Aussparungen jeweils kleiner als die jeweilige, ihnen zugeordnete Kontaktierfläche sind. Anschließend wird die Folie auf die Gesamtheit von Leitern auflaminiert, ein Halbleiterchip auf der Chipinsel befestigt und mittels Bonddrähten mit den Kontaktierflächen elektrisch verbunden. Zum Schluß wird ein aushärtbarer Kunststoff in die Aussparungen gefüllt.

Bei dem bekannten Verfahren sind für die Chipinsel und die Kontaktierflächen jeweils einzelne Aussparungen in der Folie angebracht. Dadurch ist es nötig, daß sowohl der Halbleiterchip als auch die Bonddrähte genau plaziert werden müssen, was einen hohen Fertigungsaufwand bedeutet.

Auch die US-PS 4, 674,175 bzw. die EP 0 197 438 beschreibt ein Verfahren zur Montage von integrierten Halbleiterschaltungen. Dort wird statt einer Folie ein Kunststoffplättchen auf die Gesamtheit von Leitern aufgebracht. Dieses Kunststoffplättchen hat eine Aussparung sowohl für den Halbleiterchip als auch für die Bonddrähte. Allerdings weist diese Aussparung eine Form auf, bei der die Verbindungen von der Chipinsel zu den Kontaktierflächen durch fingerartige Fortsätze gebildet sind. Das bedeutet, daß die Bonddrähte genau in diesen fingerartigen Fortsätzen geführt und plaziert werden müssen, was einen hohen Fixierungsaufwand bei der Montage bedeutet.

Die CH 663 115 A5 offenbart ein Verfahren, bei dem ein mit einer Aussparung versehener Trägerfilm mit einem leitenden Material kaschiert wird. Anschließend werden mittels Ätztechnik Kontaktflächen auf dem leitenden Material erzeugt. In die Aussparung im Filmstreifen wird dann ein Halbleiterchip eingesetzt, der anschließend mittels Bonddrähten mit den Kontaktflächen elektrisch verbunden wird. Zum Schluß wird die Aussparung mit einem aushärtenden Kunststoff vergossen.

Aufgabe der vorliegenden Erfindung ist es somit, ein einfacheres Verfahren zur Montage von integrierten Halbleiterschaltkreisen anzugeben.

Diese Aufgabe wird durch das Verfahren des Anspruchs 1 gelöst. Weiterbildungen sind Kennzeich en der Unteransprüche.

Vorteil der Erfindung ist, daß durch Verwendung einer Folie anstelle eines vorgestanzten Glasepoxides, welches auf das die Leiterbahnen bildende sogenannte Lead frame auflaminiert wird, eine einfachere Drahtführung ermöglicht wird, da nicht mehr in ein Bondloch hineingebondet werden muß.

Ein weiterer Vorteil besteht darin, daß die Folie mit ihren Aussparungen gleichzeitig als automatischer Vergußstopper dienen kann.

Wird wie in der Weiterbildung der Erfindung angegeben, eine beidseitig beschichtete Klebefolie verwendet, so ermöglicht diese einen einfachen Einbau in die Karte ohne zusätzliche Klebstoffe oder Laminate, wie es bisher üblich war.

Verwendet man eine sehr elastische Folie, so macht diese vorteilhafterweise die Biegewechsel mit, der Chip selbst ist durch einen harten Verguß geschützt.

Die vorteilhafte Ausgestaltung der Aussparungen innerhalb der Folie sichert eine gute Verankerung des Vergusses mit der Folie.

Die Erfindung wird nachfolgend anhand von drei Figuren näher erläutert. Es zeigen:
Figur 1 eine Draufsicht auf ein durch das erfindungsgemäße Verfahren hergestellten Halbleiterschaltkreis,
Figur 2 eine Schnittansicht entlang der in Figur 1 gekennzeichneten Schnittlinie ohne Verguß,
Figur 3 eine Schnittansicht entlang der in Figur 2 gekennzeichneten Schnittlinie mit dem Verguß.

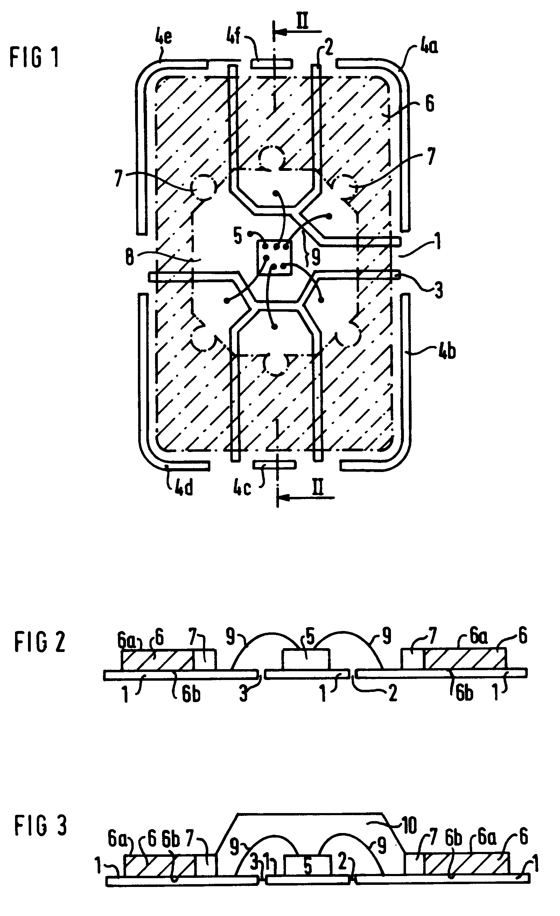

In Figur 1 ist das sogenannte Lead frame mit 1 bezeichnet. Dieses ist wie in der Halbleitertechnik üblich, durch Stanztechnik strukturiert und kann beliebig veredelt sein. Die durch das Stanzen entstandenen Aussparungen sind mit 2, 3 sowie 4a,...4f bezeichnet. Auf dieses Lead frame 1 wird eine Folie 6 auflaminiert. Diese weist die Größe der Fläche auf, die durch die Rand bestimmenden Aussparungen 4a,...4f vorgegeben sind. Diese Folie kann z. B. eine doppelseitig beschichtete Klebefolie sein. Die Folie 6 weist eine Aussparung 8 auf, welche ein Plazieren und Bonden eines Mikroschaltkreises 5 ermöglicht. An den Rändern der Aussparung 8 sind zusätzliche Aussparungen 7 vorgesehen. Diese sind tangential am Rand der Aussparung 8 angeordnet. Die zusätzlichen Aussparungen sind vorzugsweise kreisförmig und zeigen in Richtung der Ränder der Anordnung. Die Bonddrähte sind in Figur 1 mit 9 bezeichnet. Sie führen von den einzelnen Anschlußpads des Schaltkreises 5 zu den jeweiligen Leiterbahnen des Lead frame 1.

Erfindungsgemäß sollte die Aussparung 8 genügend Platz zum Befestigen des Mikroschaltkreises 5 und zum Bonden der Bonddrähte 9 freilassen, um so ein einfaches Bonden zu gewährleisten. Die Form der Aussparung 8 spielt dabei keine Rolle, kann aber vorzugsweise kreisförmig gestaltet sein. Die zusätzlichen am Rand der Aussparung 8 vorgesehenen Aussparungen dienen im wesentlichen zur sicheren Verankerung der Vergußmasse mit dem Lead frame, welche den Schaltkreis und seine Verbindungen abdeckt.

Die in den Figuren 2 und 3 dargestellten Schnitte entlang der in Figur 1 gekennzeichneten Linien stellen die gemäß dem erfindungsgemäßen Verfahren hergestellte Anordnung vor und nach dem Vergießen dar. So zeigt Figur 2 die Anordnung vor dem Verguß. Alle dargestellten Bezugszeichen entsprechen denen aus Figur 1. Zusätzlich sind mit 6a und 6b die Ober- und Unterseite der Folie bezeichnet. Diese beiden Flächen können z. B. jeweils mit einem Laminierkleber beschichtet sein. Die Schicht 6b ermöglicht ein einfaches Befestigen der Folie 6 auf dem Lead frame 1. Das Vergießen des Schaltkreises 5 und seiner Anschlüsse 9 erfolgt in üblicher Weise. Dabei dient die Folie mit ihren Aussparungen 7, 8 als Vergußstopper. Die in Figur 3 mit 10 bezeichnete Vergußmasse kann z. B. eine Epoxidpreßmasse sein. Zur Verankerung füllt diese auch die Aussparungen 7 aus. Vorteilhafterweise ist die Epoxidpreßmasse derart ausgebildet, daß sie aushärtbar und lichtundurchlässig ist.

Wie bereits beschrieben, ermöglicht die zweite Kleberschicht 6a einen einfachen Einbau der gesamten Anordnung in eine Chipkarte ohne zusätzliche Klebstoffe oder Laminate wie es bisher üblich war. Das ausgestanzte Modul wird in die Aussparung z. B. einer PVC-Karte gesetzt und unter Temperatur, Druck und Zeit mit ihr verbunden. Die hier verwendete sehr elastische Folie macht sehr vorteilhaft die Biegewechsel mit, wobei der Schaltkreis 5 selbst durch den harten Verguß/Umhüllung 10 geschützt ist. Über die Verankerungen in den Aussparungen 7 ist der Verguß sicher mit der Folie und den Leiterbahnen verbunden.

## Patentansprüche

1. Verfahren zur Herstellung eines Moduls für eine IC-Karte mit folgenden Schritten:
a) Herstellen einer ebenen Gesamtheit von Leitern (1), wobei ein Bereich eines der Leiter als Chipinsel etwa in der Mitte der Gesamtheit von Leitern angeordnet ist und jeweils ein Ende jedes der anderen Leiter als Kontaktierfläche diesem Bereich benachbart ist,
b) Anbringen einer Aussparung (8) in einer Folie (6), wobei die Abmessung der Aussparung (8) zumindest der Summe der Fläche der Chipinsel und der Flächen der Kontaktierflächen entspricht, und wobei die Aussparung im wesentlichen die Form eines Polygons hat,
c) Auflaminieren der Folie (6) auf die Gesamtheit von Leitern (1),
d) Befestigen eines Halbleiterchips (5) auf der Chipinsel,
e) Elektrisches Verbinden des Halbleiterchips (5) mit den Kontaktflächen der Leiter mittels Bonddrähten (9),
f) Ausfüllen der Aussparung (9) mit einem aushärtbaren Kunststoff (10).

2. Verfahren nach Anspruch 1, **dadurch gekennzeichnet**, daß die Folie (6) mindestens eine weitere Aussparung (7) umfaßt, welche tangential am Rand der Aussparung (8) angeordnet ist.

3. Verfahren nach Anspruch 1 oder 2, **dadurch gekennzeichnet**, daß als Folie (6) eine doppelseitig beschichtete Klebefolie verwendet wird.

4. Verfahren nach Anspruch 1, 2 oder 3, **dadurch gekennzeichnet**, daß die Aussparungen (8) und/oder die weiteren Aussparungen (7) kreisförmig sind.

5. Verfahren nach einem der Ansprüche 1 bis 4, **dadurch gekennzeichnet**, daß pro Leiterbahn (1) wenigstens eine weitere Aussparung (7) vorgesehen ist.
